# EUROPEAN PATENT APPLICATION

(11) **EP 3 355 362 A1**
(43) Date of publication of application: **01.08.2018**
(21) Application number: 17208926.0
(22) Date of filing: 20.12.2017
(51) Int. Cl.: H01L 31/0224, H01L 31/0336, H01L 31/074, H01L 31/0747

(54) **SOLAR CELL AND METHOD FOR MANUFACTURING THE SAME**

(30) Priority: 26.01.2017 KR 20170012697
(71) Applicant: LG Electronics Inc., Seoul 07336 (KR)
(72) Inventor: LEE, Seunghun, 08592 Seoul (KR); JUNG, Ilhyoung, 08592 Seoul (KR); KIM, Hyunho, 08592 Seoul (KR)
(74) Representative: Katérle, Axel

(57) **Abstract**

Disclosed in a solar cell including: a semiconductor substrate; a first conductive region for extracting a first carrier on the semiconductor substrate; a second conductive for extracting a second carrier on the semiconductor substrate; a first electrode electrically coupled to the first conductive region; and a second electrode electrically coupled to the second conductive region. The first conductive region includes a first compound layer having a first metal, and the second conductive region includes a second compound layer having a second metal. At least one of the first electrode and the second electrode includes a transparent electrode layer, and a metal electrode layer on the transparent electrode layer. A work function of the transparent electrode layer of the at least one of the first electrode and the second electrode is the same as or greater than a work function of the second conductive region and is the same as or smaller than a work function of the first conductive region.

## Description

### CROSS-REFERENCE TO RELATED APPLICATION

This application claims the priority benefit of Korean Patent Application No. 10-2017-0012697 filed in the Korean Intellectual Property Office on January 26, 2017, the disclosure of which is incorporated herein by reference.

### TECHNICAL FIELD

Implementations of the invention relate to a solar cell and a method for manufacturing the same, and, more particularly, to a solar cell including a semiconductor substrate and a compound layer and a method for manufacturing the same.

### BACKGROUND

Recently, as existing energy resources such as petroleum and coal are expected to be depleted, interest in alternative energy to replace them is increasing. Among them, a solar cell that converts solar energy into electric energy is attracting attention as a next-generation battery.

Such a solar cell may be manufactured by forming various layers and various electrodes according to desired designs. In connection with this, efficiency of the solar cell may be determined according to designs of the various layers and electrodes. For commercial availability of such a solar cell, it is necessary to overcome problems associated with a low efficiency of the solar cell. Accordingly, the various layers and the various electrodes are needed to be designed and manufactured in order to maximize the efficiency of the solar cell.

For example, in the conventional solar cell manufactured by doping a semiconductor substrate with a dopant, a doping process or the like is complicated, and an interfacial property of the semiconductor substrate may be deteriorated and thus a passivation property may be deteriorated. In another solar cell using compound layers as conductive regions in order to prevent this, the compound layers have different materials from each other, and thus, stability may be deteriorated and a manufacturing process may be difficult to be simplified.

### SUMMARY

Therefore, implementations of the invention have been made in view of the above problems, and the implementations of the invention are to provide a solar cell having enhanced efficiency and stability and a high productivity, and a method for manufacturing the same.

A solar cell according to an implementation of the invention includes: a semiconductor substrate; a first conductive region for extracting a first carrier on the semiconductor substrate; a second conductive for extracting a second carrier on the semiconductor substrate; a first electrode electrically coupled to the first conductive region; and a second electrode electrically coupled to the second conductive region. The first conductive region includes a first compound layer having a first metal, and the second conductive region includes a second compound layer having a second metal. At least one of the first electrode and the second electrode includes a transparent electrode layer, and a metal electrode layer on the transparent electrode layer. A work function of the transparent electrode layer of the at least one of the first electrode and the second electrode is the same as or greater than a work function of the second conductive region and is the same as or smaller than a work function of the first conductive region.

A method for manufacturing a solar cell according to an implementation of the invention includes: forming a first conductive region including a first compound layer having a first metal and a second conductive region including a second compound layer having a second metal, on a semiconductor substrate; forming a first transparent electrode layer of a first electrode electrically coupled to the first conductive region and a second transparent electrode layer of a second electrode electrically coupled to the second conductive region; and forming a first metal electrode layer of the first electrode on the first transparent electrode layer and a second metal electrode layer of the second electrode on the second transparent electrode layer. A work function of at least one of the first and second transparent electrode layers is the same as or greater than a work function of the second conductive region and is the same as or smaller than a work function of the first conductive region.

According to the implementation, by minimizing a difference between work functions of transparent electrode layers included in a first electrode and a second electrode, properties of the transparent electrode layers of the first electrode and the second electrode can be the same as or similar to each other and a manufacturing process can be simplified. Thereby, stability and productivity of the solar cell can be improved while maintaining excellent efficiency of the solar cell.

### BRIEF DESCRIPTION OF THE DRAWINGS

The above and other objects, features and other advantages of the invention will be more clearly understood from the following detailed description taken in conjunction with the accompanying drawings, in which:
FIG. 1 is a cross-sectional view of a solar cell according to an implementation of the invention;
FIG. 2 is a front plan view of the solar cell shown in FIG. 1;
FIG. 3 shows a band diagram of a first transparent electrode layer, a first conductive region, a first passivation layer, a semiconductor substrate, a second passivation layer, a second conductive region, and a second transparent electrode layer in a solar cell according to an implementation of the invention;
FIGS. 4a to 4d are cross-sectional views showing a method for manufacturing a solar cell according to an implementation of the invention;
FIG. 5 is a cross-sectional view of a solar cell according to another implementation of the invention; and
FIG. 6 is a rear plan view of the solar cell shown in FIG. 5.

### DETAILED DESCRIPTION

Reference will now be made in detail to various implementations of the invention, examples of which are illustrated in accompanying drawings. The invention may, however, be implemented in many alternate forms and should not be construed as limited to the implementations set forth herein.

In the drawings, illustration of parts unrelated to implementations of the invention is omitted for clarity and simplicity of description. The same reference numerals designate the same or substantially similar elements throughout the specification. In the drawings, thicknesses, widths or the like of elements are exaggerated or reduced for clarity of description, and should not be construed as limited to those illustrated in the drawings.

It will be understood that the terms "comprise" and/or "comprising," or "include" and/or "including" used in the specification specify the presence of stated elements, but do not preclude the presence or addition of one or more other elements. In addition, it will be understood that, when an element such as a layer, film, region, or plate is referred to as being "on" another element, it may be directly disposed on another element or may be disposed such that an intervening element is also present therebetween. Accordingly, when an element such as a layer, film, region, or plate is disposed "directly on" another element, this means that there is no intervening element between the elements.

Hereinafter, a solar cell and a method for manufacturing the same according to implementations of the invention will be described in detail with reference to the accompanying drawings.

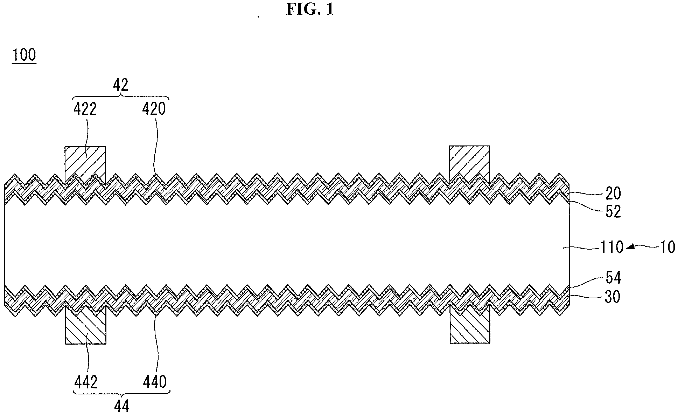

FIG. 1 is a cross-sectional view of a solar cell according to an implementation of the invention.

Referring to FIG. 1, a solar cell 100 according to the implementation includes a semiconductor substrate 10, a first conductive region 20 including a first compound layer for extracting a first carrier and positioned on the semiconductor substrate 10, a second conductive region 30 including a second compound layer for extracting a second carrier and positioned on the semiconductor substrate 10, a first electrode 42 electrically coupled to the first conductive region 20, and a second electrode 44 electrically coupled to the second conductive region 30. In this instance, a work function of a transparent electrode layer 420 and/or 440 included in at least one of the first electrode 42 and the second electrode 44 is the same as or greater than a work function of the second conductive region 30 and is the same as or smaller than a work function of the first conductive region 20. Also, the solar cell 100 may include a first passivation layer 52 and/or a second passivation layer 54. Here, the term of the first conductive region 20 or the second conductive region 30 means only that the first conductive region 20 or the second conductive region 30 extracts a carrier having a certain conductive type, and does not mean that the first or second conductive region 20 has a first or second conductivity type dopant (for example, a p-type dopant or an n-type dopant). In fact, in the implementation, the first and second conductive regions 20 and 30 may not include a dopant.

The semiconductor substrate 10 may include a base region 110 having a first or second conductivity type. The base region 110 may have a first or second conductivity type dopant with a relatively low doping concentration. The base region 110 may be formed of a single crystalline semiconductor (e.g., a single-crystalline or polycrystalline semiconductor of a single material, such as a single-crystalline or polycrystalline silicon, more particularly, a single-crystalline silicon) including an n-type or p-type dopant. The solar cell 100 based on the semiconductor substrate 10 or the base region 110 having a high degree of crystallinity and having few defects has an excellent electrical property. In the implementation, the semiconductor substrate 10 may be formed of only the base region 110 without a doped region formed by an additional doping or the like. As a result, a deterioration of a passivation property of the semiconductor substrate 10 due to the doped region can be prevented.

As an example, in the implementation, the base region 110 may be doped with an n-type dopant to have an n-type. If the base region 110 has the n-type, the first and second conductive regions 20 and 30 may be formed of compound materials that may be easily obtained and the first and second conductive regions 20 and 30 may be easily formed. Specific materials of the first and second conductive regions 20 and 30 will be described later in detail.

An anti-reflection structure capable of minimizing reflection may be formed on front and back surfaces of the semiconductor substrate 10. For example, a texturing structure having a concavo-convex shape in a form of a pyramid or the like may be provided as the anti-reflection structure. The texturing structure formed on the semiconductor substrate 10 may have a certain shape (e.g., a pyramid shape) having outer surfaces formed along a specific crystal plane (e.g., (111) plane) of a semiconductor. When a surface roughness of the semiconductor substrate 10 is increased by forming concaves and convexes on the front surface and so on of the semiconductor substrate 10 by such texturing, reflectivity of light incident into the semiconductor substrate 10 can be reduced to minimize an optical loss. However, the implementations of the invention are not limited thereto. The anti-reflection structure may be formed on only one surface of the semiconductor substrate 10, or an anti-reflection structure may not be formed on the front and back surfaces of the semiconductor substrate 10.

The first passivation layer 52 may be formed on (e.g., may be in contact with) the front surface of the semiconductor substrate 10. The first passivation layer 52 may improve a passivation property of a surface of the semiconductor substrate 10. Also, the first passivation layer 52 may act as a kind of a barrier to electrons and holes. More particularly, the first passivation layer 52 may prevent the second carriers from passing and may allow only the first carriers to pass through the first passivation layer 52 when the first carriers have energy above a certain level after the first carriers are accumulated at a portion adjacent to the first passivation layer 52. In this instance, the first carriers having the energy above the certain level can easily pass through the first passivation layer 52 by a tunneling effect.

The first passivation layer 52 may be formed entirely on the front surface of the semiconductor substrate 10. Accordingly, the first passivation layer 52 can be easily formed without any additional patterning while having an excellent passivation property. The first passivation layer 52 may be an undoped layer having no dopant.

For example, the first passivation layer 52 may include any of an oxide, a nitride, a semiconductor, a conductive polymer, or the like. For example, the first passivation layer 52 may include a silicon oxide, a silicon nitride, a silicon oxynitride, a silicon carbide, an intrinsic amorphous semiconductor, an intrinsic polycrystalline semiconductor, or the like. In particular, the first passivation layer 52 may be formed of a silicon oxide layer including a silicon oxide. This is because the silicon oxide layer is excellent in passivation property and the carriers can be easily transferred through the silicon oxide layer by a tunneling. Such a silicon oxide layer may be formed by a thermal oxidation or a chemical oxidation. Alternatively, the first passivation layer 52 may be formed of an intrinsic amorphous silicon (i-a-Si) layer. Then, the first passivation layer 52 includes the same material as the semiconductor substrate 10 and thus the first passivation layer 52 may have properties similar to properties of the semiconductor substrate 10. Thus, the passivation property can be improved more effectively. However, the implementations of the invention are not limited thereto. Accordingly, the first passivation layer 52 may be formed of an intrinsic amorphous silicon carbide (i-a-SiCx) layer or an intrinsic amorphous silicon oxide (i-a-SiOx) layer. According to this, an effect due to a wide energy band gap can be improved, but the passivation property may be lower to some degrees than the implementation including the intrinsic amorphous silicon (i-a-Si) layer.

The first conductive region 20 may be positioned on (e.g., may be in contact with) the first passivaiton layer 52. However, the first passivation layer 52 is not an essential layer, and thus, the first conductive region 20 may be in contact with the semiconductor substrate 10 without the first passivation layer 52. The first conductive region 20 may be entirely formed on the first passivation layer 52. Then, the first conductive region 20 has a sufficient area, and thus, an area of the first conductive region contributing to a photoelectric conversion can be maximized. In the implementation, the first conductive region 20 includes the first compound layer (for example, a first metal oxide layer), which will be described later in more detail.

The first conductive region 20 may selectively extract and collect first carriers and transmit the extracted first carriers to the first electrode 42. In one example, the first carrier may correspond to a minority carrier of the semiconductor substrate 10. For example, when the semiconductor substrate 10 has an n-type, a majority carrier is an electron and a minority carrier is a hole. In this instance, the first conductive region 20 may extract and collect holes as the first carriers. Then, the first conductive region 20 may constitute an emitter region. Then, the emitter region, which is positioned on the front surface of the semiconductor substrate 10 and substantially acts a photoelectric conversion, can effectively extract and collect the holes having a relatively slow moving speed.

A thickness of the first passivation layer 52 may be the same as, less than, or greater than a thickness of the first conductive region 20. In the implementation, the first conductive region 20 may be formed of a first compound layer (for example, a first metal oxide layer) having an amorphous structure. The amorphous structure of the first conductive region 20 may be formed and maintained when the first conductive region 20 is thin. Accordingly, the first conductive region 20 has a small thickness in the implementation, and thus, the implementations of the invention is not limited in that the thickness of the first passivation layer 52 is less than the thickness of the first conductive region 20. For example, the thickness of the first conductive region 20 may be minimized so that the first conductive region 20 has a more stable amorphous structure, and, in this instance, the thickness of the first conductive region 20 may be the same as or less than the thickness of the first passivation layer 52. As another example, the thickness of the first passivation layer 52 may be reduced to maximize a tunneling effect through the first passivation layer 52, and, in this instance, the thickness of the first passivation layer 52 may be less than the thickness of the first conductive region 20.

Alternatively, the thickness of the first passivation layer 52 may be 10 nm or less, and the thickness of the first conductive region 20 may be 30 nm or less (for example, 10 nm or less). If the thickness of the first passivation layer 52 is greater than 10 nm, the tunneling does not occur smoothly, and the solar cell 100 may not operate smoothly. If the thickness of the first conductive region 20 is greater than 30 nm, the first conductive region may not have an amorphous structure and the first carriers may not smoothly flow due to a low electrical conductivity. In this instance, when the first conductive region 20 has a thickness of 10 nm or less, the amorphous structure of the first conductive region 20 can be stably maintained.

For example, the thickness of the first passivation layer 52 may be 5 nm or less (more particularly, 2 nm or less, for example, 0.5 nm to 2 nm) in order to sufficiently realize the tunneling effect. If the thickness of the first passivation layer 52 is less than 0.5 nm, it may be difficult to form the first passivation layer 52 of desired quality. The first conductive region 20 may have the thickness of 2 nm or more (for example, 5 nm or more) so as to stably extract and collect the first carriers. However, the implementations of the invention are not limited thereto, and the thickness of the first passivation layer 52 and/or the thickness of the first conductive region 20 may have any of various values.

The first electrode 42 electrically coupled to the first conductive region 20 may be formed on (e.g., may be in contact with) the first conductive region 20. For example, the first electrode 42 may include a first transparent electrode layer 420 and a first metal electrode layer 422 that are sequentially stacked on the first conductive region 20.

In this instance, the first transparent electrode layer 420 may be formed on (e.g., may be in contact with) the first conductive region 20 to have a relatively large area. For example, the first transparent electrode layer 420 may be formed entirely on the first conductive region 20. When the first transparent electrode layer 420 is formed on the first conductive region 20 as described above, the first carriers can easily reach the first metal electrode layer 422 through the first transparent electrode layer 420, and thus, a resistance in a lateral direction can be reduced. In particular, in the implementation, the first conductive region 20 is formed of an undoped first compound layer that does not include a dopant, and thus, a resistance of the first conductive region may be increased. Therefore, the first transparent electrode layer 420 may be provided to effectively reduce the resistance.

As described above, since the first transparent electrode layer 420 is formed on the first conductive region 20 with a large area, the first transparent electrode layer 420 may be formed of a light-transmitting material (a transparent material). That is, the first transparent electrode layer 420 may be formed of a transparent conductive material so that the first carriers can be easily transferred through the first transparent electrode 420 and light can penetrate through the first transparent electrode 420. Accordingly, even if the first transparent electrode layer 420 is formed on the first conductive region 20 with a large area, the transmission of light is not blocked. A work function, a material, or so on of the first transparent electrode layer 420 will be described later in more detail.

The first metal electrode layer 422 may be formed on the first transparent electrode layer 420. For example, the first metal electrode layer 422 may be in contact with the first transparent electrode layer 420 to simplify the structure of the first electrode 42. However, the implementations of the invention are not limited to this, and various modifications such as there is a separate layer between the first transparent electrode layer 420 and the first metal electrode layer 422 are possible.

The first metal electrode layer 422 positioned on the first transparent electrode layer 420 may be formed of a material having an electrical conductivity higher than that of the first transparent electrode layer 420. Thus, a property such as carrier collection efficiency can be further improved and a resistance can be effectively reduced by the first metal electrode layer 422. For example, the first metal electrode layer 422 may be formed of an opaque material having an electrical conductivity higher than that of the first transparent electrode layer 420 or a metal having a transparency lower than that of the first transparent electrode layer 420.

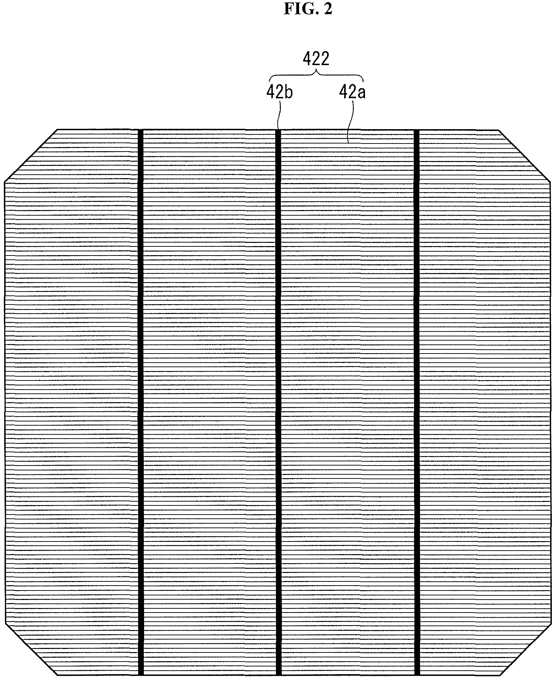

Since the first metal electrode layer 422 is opaque or has low transparency, it may interfere with the incidence of light, so that the first metal electrode layer 422 may have a certain pattern so as to minimize a shading loss. The first metal electrode layer 422 has an area smaller than that of the first transparent electrode layer 420. Thus, the light can be incident on a portion where the first metal electrode layer 422 is not formed. A planar shape of the first metal electrode layer 422 will be described later in more detail with reference to FIG. 2.

In the implementation, since the first metal electrode layer 422 is formed adjacent to or in contact with the first transparent electrode layer 420, a fire-through for penetrating an insulating layer or the like is not required. The first metal electrode layer 422 may be formed by coating (e.g., by a printing) a low-temperature-firing paste that can be fired at a low temperature (350°C or less, for example, 300°C or less, as an example, 250°C or less) and heat-treating it. Various materials known as low-temperature-firing pastes may be used for the low-temperature-firing paste.

Hereinafter, an example of a planar shape of the first metal electrode layer 422 of the first electrode 42 will be described in detail with reference to FIGS. 1 and 2. FIG. 2 is a front plan view of the solar cell 100 shown in FIG. 1. For the simplicity, the first transparent electrode layer 420 of the first electrode 42 is not shown in FIG. 2.

Referring to FIG. 2, the first metal electrode layer 422 of the first electrode 42 may include a plurality of finger electrodes 42a spaced apart from each other with a predetermined pitch. Although the finger electrodes 42a are parallel to each other and parallel to an edge of the semiconductor substrate 10 in FIG. 2, the implementations of the invention are not limited thereto. The first metal electrode layer 422 of the first electrode 42 may include a bus bar electrode 42b connecting the finger electrodes 42a in a direction crossing (for example, perpendicular to) the finger electrodes 42a. Only one bus bar electrode 42b may be provided or a plurality of bus bar electrodes 42b may be provided with a pitch greater than the pitch of the finger electrodes 42a, as shown in FIG. 2. In this instance, a width of the bus bar electrode 42b may be larger than a width of the finger electrode 42a, but the implementations of the invention are not limited thereto. Therefore, the width of the bus bar electrode 42b may be the same as or smaller than the width of the finger electrode 42a.

Referring to FIG. 1 again, the second passivation layer 54 may be positioned on (e.g., may be in contact with) a back surface of the semiconductor substrate 10, and the second conductive region 30 may be positioned on (e.g., may be in contact with) the second passivation layer 54. However, the second passivation layer 54 is not an essential layer, and thus, the second conductive region 30 may be in contact with the semiconductor substrate 10 without the second passivation layer 54. Also, the second electrode 44 electrically coupled to the second conductive region 30 may be positioned on (e.g., may be in contact with) the second conductive region 30. The second electrode 44 may include a second transparent electrode layer 440 and a second metal electrode layer 442 which are sequentially stacked on the second conductive region 30.

The second conductive region 30 may include or be formed of a second compound layer being able to selectively extract and collect second carriers having a conductive type opposite to a conductive type of the first carriers. In one example, the second carrier may correspond to a majority carrier of the semiconductor substrate 10. For example, when the semiconductor substrate 10 has an n-type, a majority carrier is an electron and a minority carrier is a hole. In this instance, the second conductive region 30 may extract and collect electrodes as the second carriers. Then, the second conductive region 30 may constitute a field region (particularly, a back surface field region). However, the implementations of the invention are not limited thereto.

The second passivation layer 54 may improve a passivation property of a surface of the semiconductor substrate 10. Also, the second passivation layer 54 may prevent the first carriers from passing and may allow only the second carriers to pass through the second passivation layer 54 when the second carriers have energy above a certain level after the second carriers are accumulated at a portion adjacent to the second passivation layer 54. In this instance, the second carriers having the energy above the certain level can easily pass through the second passivation layer 54 by a tunneling effect.

Except for the differences described above and except that the second passivation layer 54, the second conductive region 30, and the second electrode 44 are positioned on the back surface of the semiconductor substrate 10, the descriptions of the first passivation layer 52, the first conductive region 20, and the second electrode 44 may be applied to the second passivation layer 54, the second conductive region 30, and the second electrode 44, respectively, as they are. In this instance, the first passivation layer 52 and the second passivation layer 54 may have the same thickness, shape, material, or the like, or may have different thicknesses, shapes, materials, or the like. The first transparent electrode layer 420 and/or the first metal electrode layer 422 and the second transparent electrode layer 440 and/or the second metal electrode layer 442 may have the same shape and/or material, and may have different shapes and/or materials. For example, widths and pitches of the finger electrodes 42a and the bus bar electrodes 42b of the first metal electrode layer 422 may be the same as or different from widths and pitches of finger electrodes and bus bar electrodes of the second metal electrode layer 442, respectively. Alternatively, planar shapes of the first metal electrode layer 422 and the second metal electrode layer 442 may be different from each other, or stacked structures of the first electrode 42 and the second electrode 44 may be different from each other. Various other variations are possible.

Although it is not shown in FIG. 1, an insulating layer such as a passivation layer, an anti-reflection layer, a reflection layer, or the like may be further formed on the first and second conductive regions 20 and 30 and/or on the first and second transparent electrode layers 422 and 442.

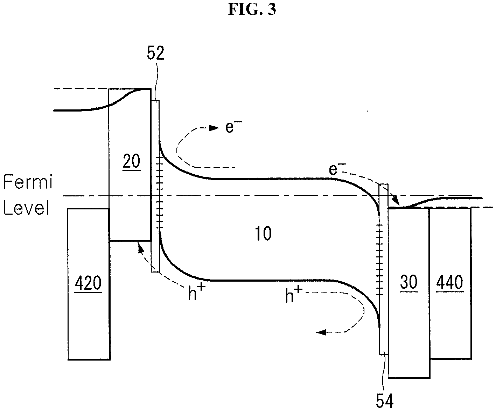

In this instance, in the implementation, the first conductive region 20 formed of the first compound layer (for example, the first metal oxide layer), the second conductive region 30 formed of the second compound layer (for example, the second metal oxide layer), and the first and/or second transparent electrode layers 420 and/or 440 may have specific work functions. This will be described in more detail with reference to FIG. 3.

FIG. 3 shows a band diagram of the first transparent electrode layer 420, the first conductive region 20, the first passivation layer 52, the semiconductor substrate 10, the second passivation layer 54, the second conductive region 30, and the second transparent electrode layer 440 in the solar cell 100 according to the implementation of the invention. In FIG. 3, a solid line is a band diagram according to the implementation of the invention, and a dotted line is a band diagram according to the conventional solar cell shown for comparison with the implementation of the invention.

The first conductive region 20 formed of the first compound layer (for example, a first metal compound layer which is a compound of a first metal and a non-metal) and the second conductive region 30 formed of the second compound layer (for example, a second metal compound layer which is a compound of a second metal and a non-metal) may selectively extract and collect the first or second carriers by a energy band difference with the semiconductor substrate 10. In this instance, the first conductive region 20 and the second conductive region 30 do not include a semiconductor material and/or a dopant of the semiconductor material in a dopant form. In this instance, the first compound layer may be formed of a first metal oxide layer including a first metal and oxygen, and the second compound layer may be formed of a second metal oxide layer including a second metal and oxygen. Then, the first and second conductive regions 20 and 30 can be easily formed and the passivation property thereof can be also excellent.

The first compound layer or the first conductive region 20 may have Fermi level lower than Fermi level of the semiconductor substrate 10 and have a relatively high work function. The second compound layer or the second conductive region 30 may have Fermi level higher than Fermi level of the semiconductor substrate 10 and have a relatively low work function, i.e., a work function lower than a work function of the first compound layer or the first conductive region 20.

When the first conductive region 20 formed of the first compound layer having above Fermi lever and the second conductive region 30 formed of the second compound layer having above Fermi level are coupled with the semiconductor substrate 10 to form junctions while interposing the first and second passivation layers 52 and 54, respectively, therebetween, the semiconductor substrate 10, the first conductive region 20, and the second conductive region 30 are coupled to each other so that Fermi level thereof has the same value, as shown in FIG. 3. Then, holes (h+) at valence band of the semiconductor substrate 10 can be easily transferred to valence band of the first conductivity region 20 when the holes pass through the first passivation layer 52. On the other hand, electrons (e-) in the semiconductor substrate 10 do not pass through the first passivation layer 52. Electrons at conduction band of the semiconductor substrate 10 can be easily transferred to conduction band of the second conduction region 30 when the electrons pass through the second passivation layer 54. On the other hand, the holes in the semiconductor substrate 10 do not pass through the second passivation layer 54.

In the implementation, a work function of at least one of the first and second transparent electrode layers 420 and 440 is the same as or greater than a work function of the second conductive region 30, and is the same as or less than a work function of the first conductive region 20. For example, the work function of at least one of the first and second transparent electrode layers 420 and 440 is greater than the work function of the second conductive region 30 and is less than the work function of the first conductive region 20. Accordingly, a work function difference between the first and second transparent electrode layers 420 and 440 can be reduced. In particular, the work function of each of the first and second transparent electrode layers 420 and 440 is the same as or greater than the work function of the second conductive region 30 and is the same as or less than the work function of the first conductive region 20. Thus, the work function difference between the first and second transparent electrode layers 420 and 440 can be greatly reduced. If the work functions of the first and second transparent electrode layers 420 and 440 are greater than a certain level, an electrical property may be deteriorated. By setting work functions as described above, the solar cell can have improved electrical properties, e.g., conductivity, and a resistance can be reduced because the work function of the first transparent electrode layer 420 or the second transparent electrode layer 440 has a certain level or less. For reference, the work function may be measured by any of various devices, such as, an ultraviolet photoelectron spectroscopy (UPS) or Kelvin probe.

When the work function difference between the first and second transparent electrode layers 420 and 440 is reduced as in the above, the first and second transparent electrode layers 420 and 440 may be formed of the same material or similar materials. According to this, the first and second transparent electrode layers 420 and 440 may have the same property or similar properties, and thus, stability can be enhanced. Further, the first and second transparent electrode layers 420 and 440 may be formed under the same process condition or similar process conditions, thereby simplifying a manufacturing process. In particular, the first and second transparent electrode layers 420 and 440 may be formed of the same material, and then, the first and second transparent electrode layers 420 and 440 can be simultaneously formed in the same process, thereby simplifying the manufacturing process more.

This effect may be increased by reducing a work function difference between the second conductive region 30 and the first conductive region 20. That is, the first and/or second transparent electrode layer 420 and/or 440 has the work function the same as or greater than the second conductive region 30 and the same as or less than the first conductive region 20. In this instance, when the work function difference between the conductive region 30 and the first conductive region 20 is reduced more, the work function difference between the first and second transparent electrode layers 420 and 440 can be minimized.

For example, as mentioned above, even though the work function of the first conductive region 20 is greater than the work function of the second conductive region 30, the work function difference between the second conductive region 30 and the first conductive region 20 may be 1eV or less. As another example, the work function difference between the second conductive region 30 and the first conductive region 20 may be 0.8eV or less. As another example, the work function difference between the second conductive region 30 and the first conductive region 20 may be in a range of 0.5 to 1eV. As another example, the work function difference between the second conductive region 30 and the first conductive region 20 may be within a range of 0.5 to 0.8eV.

By setting the work function difference as described in the examples above, the work function difference between the second conductive region 30 and the first conductive region 20 can be minimized in the state that the second conductive region 30 and the first conductive region 20 act as conductive regions. These work functions of the second conductive region 30 and the first conductive region 20 can alleviate or reduce a band bending due to the work functions of the first and second transparent electrode layers 420 and 440, which will be described later in detail. If the work function difference between the second conductive region 30 and the first conductive region 20 exceeds 1eV, the effect of minimizing the work function difference between the first and second transparent electrode layers 420 and 440 may be not sufficient and the band bending may be difficult to be alleviated or reduced. If the work function difference between the second conductive region 30 and the first conductive region 20 is less than 0.5eV, the work function of the second conductive region 30 may be not sufficiently small and the extraction and collection of electrons may not be smooth, and/or the work function of the first conductive region 20 may be not sufficiently large and the extraction and collection of holes may not be smooth. However, the implementations of the invention are not limited thereto.

In this instance, the work function of the second conductive region 30 may be greater than 4.2eV, and the work function of the first conductive region 20 may be greater than 4.2eV and may be greater than the work function of the second conductive region 30. For example, the work function of the second conductive region 30 may be greater than 4.2eV and may be the same as or less than 5.2eV, and the work function of the first conductive region 20 may be greater than 4.2eV, may be the same as or less than 5.2eV, and may be greater than the work function of the second conductive region 30. Within the above work function, the first conductive region 20 and the second conductive region 30 can effectively extract and collect holes or electrons.

According to this, the work function of the first transparent electrode layer 420 may be greater than 4.2eV and may be the same as or less than 5.2eV, and the work function of the second transparent electrode layer 440 may be greater than 4.2eV and may be the same as or less than 5.2eV. For example, the work function of the first transparent electrode layer 420 may be greater than 4.2eV and may be less than 5.0eV, and the work function of the second transparent electrode layer 440 may be greater than 4.2eV and may be less than 5.0eV. Alternatively, the work function difference between the first transparent electrode layer 420 and the second transparent electrode layer 440 may be 1eV or less, more particularly, may be less than 0.8eV, and more specifically, may be 0.2eV or less. A manufacturing process can be simplified within this range. In particular, the work function of the first transparent electrode layer 420 and the work function of the second transparent electrode layer 440 may be substantially the same and may be formed of the same material.

In the solar cell 100 according to the implementation, a manufacturing process can be simplified by limiting the work function as in the above. Even in this case, there is no problem related to the extraction and the collection of carriers of the first conductive region 20 and the second conductive region 30. In this regard, the conventional solar cell will be described first, and then, the solar cell 100 according to the implementation will be described.

In some implementations, as shown by the dotted line in FIG. 3, work functions of the first transparent electrode layer 420, the first conductive region 20, the second transparent electrode layer 440, and the second conductive region 30 are designed to have a flat band in the first transparent electrode layer 420, the first conductive region 20, the second transparent electrode layer 440, and the second conductive region 30. Then, the second conductive region 30 had a work function that is a certain level or less, and the first conductive region 20 had a work function greater than the work function of the second conductive region 30 (for example, by an amount greater than 0.8eV; as another example, by an amount greater than 1eV). In this instance, the second transparent electrode layer 440 has a work function the same as or less than that of the second conductive region 30, and the first transparent electrode layer 420 had a work function the same as or greater than that of the first conductive region 20. Thus, the work function difference between the second conductive region 30 and the first conductive region 20 is greater than 0.8eV (or greater than 1eV), and the work functions of the first and second transparent electrode layers 420 and 440 are not the same as or greater than the work function of the second conductive region 30 and are not the same as or less than the work function of the first conductive region 20. Therefore, the work function difference between the first transparent electrode layer 420 and the second transparent electrode layer 440 is 0.8eV or more, e.g., greater than 1eV, and the first transparent electrode layer 420 and the second transparent electrode layer 440 are formed of different materials or have completely different compositions. Accordingly, since the first transparent electrode layer 420 and the second transparent electrode layer 440 are formed under different process conditions in different processes, the manufacturing process of the solar cell is complicated.

The solar cell 100 in FIG. 3 can have a band bending or a band-offset at a certain degree in the first conductive region 20 and the first transparent electrode layer 420 and in the second conductive region 30 and the second transparent electrode layer 440 because the work function difference between the first transparent electrode layer 420 and the second transparent electrode layer 440 is low or the work functions of the first and second transparent electrode layers 420 and 440 have values between the work function of the second conductive region 30 and the work function of the first conductive region 20. However, the band bending or the band offset does not significantly affect a selective extraction of carriers, and may be alleviated or reduced by setting the work functions of the second conductive region 30 and the first conductive region 20 as described above. Accordingly, even if there is the band bending in the solar cell 100, the first and second conductive regions 20 and 30 can efficiently perform selective extracting of carriers such that the solar cell 100 can have improved efficiency. In addition, the first and second transparent electrode layers 420 and 440 may be formed using the same process or the substantially similar process such that the manufacturing process of the solar cell 100 can be simplified.

As an example, a band gap of the second conductive region 20 and/or a band gap of the first conductive region 20 may be 3.0eV or more. Carriers can be selectively extracted and collected effectively within this band gap. However, the implementations of the invention are not limited thereto.

In the implementation, the first compound layer that may be used for the first conductive region 20 may include a molybdenum oxide layer formed of a molybdenum oxide, a tungsten oxide layer formed of a tungsten oxide (e.g., WO₃), a vanadium oxide layer formed of a vanadium oxide, a nickel oxide layer formed of a nickel oxide, a rhenium oxide layer formed of a rhenium oxide, or the like. In particular, when the first conductive region 20 includes the molybdenum oxide layer or the tungsten oxide layer, the effect of selectively collecting holes may be excellent.

Also, in the implementation, the second compound layer that may be used for the second conductive region 30 may include a titanium oxide layer formed of a titanium oxide (e.g., TiO₂), a zinc oxide layer formed of a zinc oxide(e.g., ZnO), a niobium oxide layer formed of a niobium oxide (e.g., Nb₂O₅), or the like. In particular, when the second conductive region 30 includes the titanium oxide layer, the effect of selectively collecting electrons may be excellent.

The first conductive region 20 and the second conductive region 30 having the above work functions may be formed by adjusting process conditions of them, compositions of them, or the like. For example, when the first or second conductive region 20 or 30 includes a metal and oxygen, a content of the oxygen and/or the metal may be controlled by adjusting process conditions during a manufacturing process or by performing a heat treatment after forming the first or second conductive region 20 or 30 so that the first or second conductive region 20 or 30 has a desired work function.

Also, the first and/or second transparent electrode layer 420 and/or 440 may be formed of any of various materials. In particular, the first and/or second transparent electrode layer 420 and/or 440 may be formed of a material having a work function as described above (i.e., a work function greater than 4.2eV and the same as or less than 5.2eV). For example, the first and/or second transparent electrode layer 420 and/or 440 may include or may be formed of an indium-based oxide including indium or a zinc-based oxide including zinc. For examples, the indium-based oxide may include indium-tin oxide (ITO), indium-tungsten oxide (IWO), indium-cerium oxide (ICO), or so on, and the zinc-based oxide may include aluminum-zinc oxide (AZO), gallium-zinc oxide (GZO), zirconium-zinc oxide (ZZO), or so on. In this instance, the first and/or the second transparent electrode layer 420 and/or 440 may not include a tin-based oxide including tin (particularly, a tin-based oxide not including indium). The tin-based oxide generally has a work function greater than 5.2eV. Even though the work function of the tin-based oxide may be reduced to some degrees by adjusting composition, process conditions, etc., an electrical property may be deteriorated if the work function of the tin-based oxide is reduced. However, the implementations of the invention are not limited thereto, and the first and/or second transparent electrode layer 420 and/or 440 may include any of various other materials.

In the implementation, the first or second compound layer constituting the first conductive region 20 or the second conductive region 30 is formed of a metal oxide layer (for example, a binary metal oxide layer), and thus, it can be easily formed while having excellent stability. Also, the first or second compound layer may have an amorphous structure. If the compound layer or the metal oxide layer has a crystalline structure, the passivation property may be significantly lowered and the efficiency of the solar cell 100 may be greatly lowered. The exact reason for this is not known, but this is confirmed experimentally. Although it is not clear, it is expected that, when the crystal structure is included in the binary metal oxide layer with a large amount, an optical absorption at the compound layer or the metal oxide layer may be greatly increased and thus a current loss may be induced, and a surface roughness of the compound layer or the metal oxide layer may be increased and it may act as surface defects, thereby increasing a recombination loss.

For example, at least a portion of the first or second conductive region 20 or 30 adjacent to the first or second passivation layer 52 or 54 may be formed of an amorphous area where an amorphous portion having an amorphous structure is wider than a crystalline portion having a crystalline structure. Particularly, when at least the portion of the first or second conductive region 20 or 30 adjacent to the first or second passivation layer 52 or 54 entirely has the amorphous structure, a superior passivation property can be achieved. However, the implementations of the invention are not limited thereto.

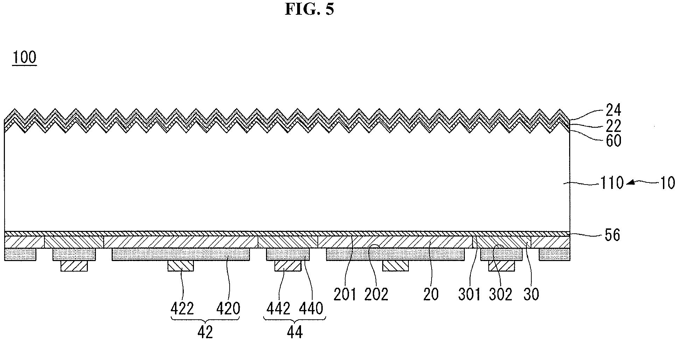

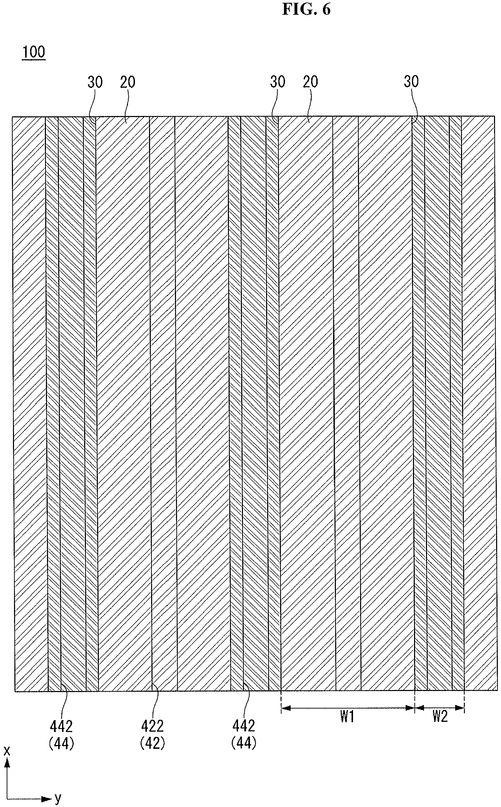

In the above descriptions and the drawings, each of the first and second metal electrode layers 422 and 442 of the solar cell 100 has a certain pattern, and thus, the solar cell 100 has a bi-facial structure being able to receive light from the front surface and the back surface of the semiconductor substrate 10. Accordingly, an amount of light used in the solar cell 100 can be increased and the efficiency of the solar cell 100 can be enhanced. However, the implementations of the invention are not limited thereto. The first or second metal electrode layer 422 or 442 may be formed entirely, and various modifications are possible. In addition, the first conductive region 20, the second conductive region 30, and the first and second electrodes 42 and 44 may be positioned together on one surface. Such an example will be described again later with reference to FIGS. 5 and 6.

When light is incident to the solar cell 100 according to the implementation, electrons and holes are generated by a photoelectric conversion, and one of the generated holes and electrons is tunneled through the first passivation layer 52, is transported to the first conductive region 20, and is then transferred to the first electrode 42, and the other is tunneled through the second passiavation layer 54, is transported to the second conductive region 30, and is then transferred to the second electrode 44 . The holes and electrons transferred to the first and second electrodes 42 and 44 move to an external circuit or other solar cell 100, thereby generating electrical energy.

The first and second conductive regions 20 and 30 are formed on the semiconductor substrate 10 while interposing the first or second passivation layer 52 or 54 therebetween, and they are separate layers from the semiconductor substrate 10. As a result, a loss due to a recombination can be minimized as compared with a case where a doped region formed by doping the semiconductor substrate 10 with the dopant is used as a conductive region. In particular, in the implementation, the first and second conductive regions 20 and 30 are formed of the first or second compound layer that does not contain a semiconductor material and a dopant, and therefore, a light absorption can be reduced, as composed with the doping region or a doped layer. Accordingly, an open-circuit voltage and a short-circuit current density of the solar cell 100 can be improved and an efficiency of the solar cell 100 can be improved. In addition, an additional doping process, an activation process for activating a dopant, or the like may be omitted. In particular, a high temperature process is not required and a process can be performed at a low temperature. Thus, a manufacturing process can be simplified and a manufacturing cost can be reduced. Accordingly, productivity of the solar cell 100 can be improved.

Particularly, by limiting work functions of the transparent electrode layers 420 and 440 in relation to work functions of the first conductive region 20 and the second conductive region 30, a difference between the work functions of the transparent electrode layers 420 and 440 can be minimized. Accordingly, properties of the transparent electrode layers 420 and 440 can be the same as or similar to each other and the manufacturing process can be simplified. Thereby, stability and productivity of the solar cell 100 can be improved while maintaining an excellent efficiency of the solar cell 100.

Hereinafter, a method for manufacturing a solar cell 100 according to an implementation will be described in detail.

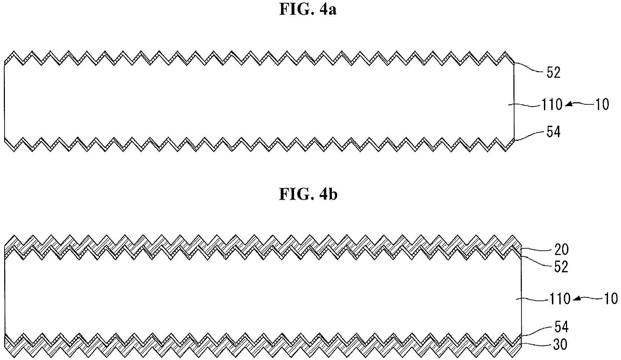

Hereinafter, a method for manufacturing a solar cell 100 according to an implementation of the invention will be described in detail with reference to FIGS. 4a to 4d.

FIGS. 4a to 4d are cross-sectional views showing a method for manufacturing a solar cell 100 according to an implementation of the invention.

As shown in FIG. 4a, first and second passivation layers 52 and 54 are formed on a front surface and a back surface of the semiconductor substrate 10, respectively. For example, the first passivation layer 52 positioned on the front surface of the semiconductor substrate 10 and the second passivation layer 54 positioned on the back surface of the semiconductor substrate 10 may be simultaneously formed in the same process. This can simplify the manufacturing process. However, the implementations of the invention are not limited thereto, and the first passivation layer 52 and the second passivation layer 54 may be formed by different processes.

The first and second passivation layers 52 and 54 may be formed by a thermal growth, a deposition (e.g., a chemical vapor deposition (PECVD), an atomic layer deposition (ALD)), a chemical oxidation, or the like. However, the implementations of the invention are not limited thereto, and the first and second passivation layers 52 and 54 may be formed by any of various methods.

In this instance, the semiconductor substrate 10 may have the front surface and/or the back surface textured to have an anti-reflection structure. Texturing of the surface of the semiconductor substrate 10 may be performed by a wet or dry texturing. The wet texturing may be performed by immersing the semiconductor substrate 10 in a texturing solution, and has an advantage of a short process time. In the dry texturing, the surface of the semiconductor substrate 10 may be cut by using a diamond grill, a laser, or the like. According to the dry texturing, the anti-reflection structure is uniformly formed, but the processing time is long and damage to the semiconductor substrate 10 may occur. Alternatively, the semiconductor substrate 10 may be textured by a reactive ion etching (RIE) or the like. As described above, the semiconductor substrate 10 may be textured in any of various methods in the implementation.

Next, as shown in FIG. 4b, a first conductive region 20 may be formed on the first passivation layer 52 and a second conductive region 30 may be formed on the second passivation layer 54. In the implementation, each of the first conductive region 20 and the second conductive region 30 formed of the first or second compound layer has an amorphous structure.

In the implementation, the first and second conductive regions 20 and 30 may be formed by any suitable process such as an atomic layer deposition (ALD), a physical vapor deposition (PVD), an e-beam evaporation, sputtering, or a chemical vapor deposition (CVD). In particular, by using the atomic layer deposition process, the first conductive region 20 and the second conductive region 30 can be formed to be thin and uniform on the semiconductor substrate 10 having the anti-reflection structure.

In the above descriptions and the drawings, it is exemplified that the first and second passivation layers 52 and 54 are formed, and then, the first and second conductive regions 20 and 30 are formed. However, the implementations of the invention are not limited thereto. The first passivation layer 52, the first conductive region 20, the second passivation layer 54, and the second conductive region 30 may be sequentially formed, or the second passivation layer 54, , the second conductive region 30, the first passivation layer 52, and the first conductive region 20 may be sequentially formed.

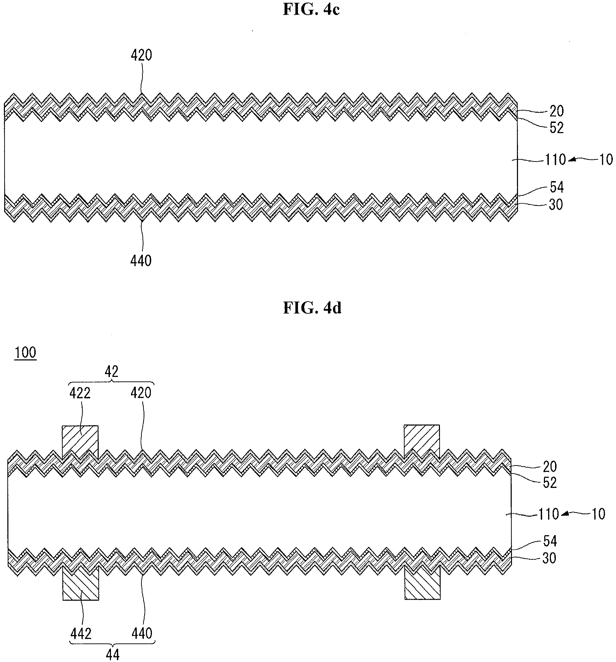

Next, as shown in FIG. 4c, a first transparent electrode layer 420 of a first electrode 42 electrically coupled to the first conductive region 20 and a second transparent electrode layer 440 of a second electrode 44 electrically coupled to the second conductive region 30 may be formed.

The first transparent electrode layer 420 and the second transparent electrode layer 440 may be formed by, for example, a deposition method (for example, a chemical vapor deposition (PECVD) method, or a reactive plasma deposition (RPD) method), an E-beam evaporation, a coating method (for example, a spin coating method), a sputtering method, or the like. In this instance, since the first transparent electrode layer 420 and the second transparent electrode layer 440 may have the same or similar materials, process conditions for forming the first transparent electrode layer 420 and the second transparent electrode layer 440 may be the same or similar to each other. Then, the manufacturing process can be simplified. Particularly, when the first transparent electrode layer 420 and the second transparent electrode layer 440 may have the same material, the first transparent electrode layer 420 and the second transparent electrode layer 440 may be formed simultaneously, and thus, the manufacturing process can be simplified more. In the conventional art, the first transparent electrode layer 420 and the second transparent electrode layer 440 are made of different materials having different work functions or having different compositions. Thus, it is hard to form the first transparent electrode layer 420 and the second transparent electrode layer 440 at the same time.

Next, as shown in FIG. 4d, a first metal electrode layer 422 of the first electrode 42 electrically coupled to the first conductive region 20 and the second metal electrode layer 442 of the second electrode 44 electrically coupled to the second conductive region 30 may be formed.

The first metal electrode layer 422 and the second metal electrode layer 442 may be formed by a plating, a printing, or the like. For example, the first metal electrode layer 422 and the second metal electrode layer 442 may be formed by printing a low-temperature-firing paste and then drying or firing the same. In this instance, the first metal electrode layer 422 and the second metal electrode layer 442 may be simultaneously formed by the same process, thereby simplifying the manufacturing process. However, the implementations of the invention are not limited thereto, and the first and second metal electrode layers 422 and 442 may be formed by any of various methods.

According to the implementation, the solar cell 100 having excellent efficiency and stability can be manufactured by a simple process. Thus, productivity of the solar cell 100 can be improved.

Hereinafter, a solar cell according to another implementation of the invention will be described in detail. Detailed descriptions will be omitted for the same or extremely similar parts as those described above, and only different parts will be described in detail. It is also within the scope of the invention to combine the above-described implementation or variations thereof with the following implementation or modifications thereof.

FIG. 5 is a cross-sectional view of a solar cell according to another implementation of the invention, and FIG. 6 is a rear plan view of the solar cell shown in FIG. 5. A first transparent electrode layer 420 of a first electrode 42 and a second transparent electrode layer 440 of a second electrode 44 are not shown in FIG. 6 for simplicity.

Referring to FIGS. 5 and 6, in the implementation, a passivation layer 56 may be disposed on a back surface of a semiconductor substrate 10, and first and second conductive regions 20 and 30 may be disposed on the passivation layer 56 to be coplanar (that is, first and second conductive regions 20 and 30 may be disposed on the same surface of the semiconductor substrate 10). A front-surface-field generating layer or a front surface field region 60 may be positioned on a front surface of the semiconductor substrate 10, and a transparent conductive layer 22 and an anti-reflection layer 24 may be disposed on the semiconductor substrate 10 or on the front surface field region 60.

As for the passivation layer 56, the descriptions of the first or second passivation layer 52 or 54 of the above-described implementation may be applied as it is. The descriptions of the first and second conductive regions 20 and 30 of the above-described implementation may be applied to the first and second conductive regions 20 and 30, respectively, as they are, except for positions and shapes of the first and second conductive regions 20 and 30. The positions and the shapes of the first and second conductive regions 20 and 30 will be described later in more detail with reference to FIG. 6.

In this instance, an anti-reflection structure may be formed at the front surface of the semiconductor substrate 10, and a back surface of the semiconductor substrate 10 may be a mirror-polished surface. This is because properties of the passivation layer 56 may greatly affect carrier mobility or the like.

In the implementation, the first and second conductive regions 20 and 30 may be disposed on (for example, may be in contact with) the passivation layer 56, and side surfaces of the first and the second conductive regions 20 and 30 may be in contact with each other. Since the first conductive region 20 and the second conductive region 30 do not include a semiconductor material and a dopant, there is no problem such as a short circuit even if the side surfaces of the first and the second conductive regions 20 and 30 are in contact with each other. However, the implementations of the invention are not limited thereto. Thus, as a modified implementation, a barrier region may be located between the first and second conductive regions 20 and 30 on the passivation layer 20 to prevent them from being in contact with each other. The barrier region may be formed of an empty space, or may be formed of an intrinsic semiconductor layer, a compound such as an oxide, or the like.

The front surface field region 60 disposed on (for example, in contact with) the front surface of the semiconductor substrate 10 may be a layer having a fixed charge or a compound layer (for example, a metal oxide layer, more particularly, a binary metal oxide layer) capable of selectively collecting electrons or holes as described above. For example, the front surface field region 60 may be an aluminum oxide layer including an aluminum oxide having a fixed charge. Alternatively, the front surface field region 60 may include a molybdenum oxide layer, a tungsten oxide layer, a vanadium oxide layer, a nickel oxide layer, a rhenium oxide layer, a titanium oxide layer, a zinc oxide layer, a niobium oxide layer, or the like, which may selectively extract and collect holes or electrons. Alternatively, the front surface field region 60 may include a plurality of the above-described layers. The front surface field region 60 may be formed of an oxide layer in order to effectively passivate an entire surface of the semiconductor substrate 10.

In this instance, the front surface field region 60 may be formed of the same layer as one of the metal compound layers constituting the first and second conductive regions 20 and 30, thereby simplifying the manufacturing process. For example, each of the front surface field region 60 and the second conductive region 30 may be formed of a titanium oxide layer.

The front surface field region 60 may act as a field region for preventing a recombination in a vicinity of the front surface of the semiconductor substrate 10 by selectively collect electrons or holes or by having a fixed charge in a state where it is not coupled to electrodes 42 and 44 coupled to other solar cell 100 or an external circuit. In this instance, the semiconductor substrate 10 does not have a doped region and consists only of a base region 110 so that defects of the semiconductor substrate 10 can be minimized.

In this instance, a thickness of the front surface field region 60 may be the same as or less than a thickness of the first or second conductive region 20 or 30. Because the front surface field region 60 is not a layer for transferring a carrier to an outside, it may have a relatively small thickness. For example, the thickness of the front surface field region 60 may be 1 nm to 10 nm. Within the thickness range, the effect of the front surface field region 60 can be sufficiently realized. However, the implementations of the invention are not limited to the thickness of the front surface field region 60.

The transparent conductive layer 22 may be positioned on (e.g., may be in contact with) the front surface of the semiconductor substrate 10 or the front surface field region 60. The transparent conductive layer 22 is a floating electrode that is not coupled to an external circuit or other solar cell 100. The floating electrode can prevent unnecessary ions or the like from gathering on the surface of the semiconductor substrate 10. Accordingly, it is possible to prevent a deterioration phenomenon (for example, a potential induced degradation (PID) of a solar cell module in a high temperature and high humidity environment). The transparent conductive layer 22 is not essential, and thus, the transparent conductive layer 22 may not be provided. In one example, the transparent conductive layer 22 may include any of various materials. For example, the transparent conductive layer 22 may be formed of a material that may be used for the first and/or second transparent electrode layer 420 and/or 440, and a material of the transparent conductive layer 22 may be the same as a material of the first and/or second transparent electrode layer 420 and/or 440.

The anti-reflection layer 24 may be positioned on (e.g., may be in contact with) the front surface of the semiconductor substrate 10 or the transparent conductive layer 22 to reduce reflectance of light. The anti-reflection layer 24 may be formed of any of various materials. For example, the anti-reflection layer 24 may be a single layer selected from the group consisting of a silicon nitride layer, a silicon nitride layer having hydrogen, a silicon oxide layer, a silicon oxynitride layer, an aluminum oxide layer, a silicon carbide layer, MgF₂, ZnS, TiO₂ and CeO₂, and may have a multi-layered structure in which two or more layers of the above are combined. As one example, the anti-reflection layer 24 may be a silicon nitride layer.

The front surface field region 60, the transparent conductive layer 22, and the anti-reflection layer 24 may be formed entirely on the front surface of the semiconductor substrate 10. Thus, a manufacturing process can be simplified and an effect of each layer can be sufficiently achieved.

In another modified implementation, a doped region formed by doping a dopant having a conductive type the same as the base region 110 to the front surface of the semiconductor substrate 10 at a high concentration may be used as the front surface field region 60, instead of the above front surface field region 60 separated from the semiconductor substrate 10. In this instance, the transparent conductive layer 22, the anti-reflection layer 24, a passivation layer or the like may be disposed on the doped region constituting the front surface field region 60.

Referring to FIG. 6 in the implementation, first conductive regions 20 and second conductive regions 30 are alternately arranged in a direction crossing a longitudinal direction of the first or second conductive region 20 or 30, and each of the first conductive regions 20 and the second conductive regions 30 may have a stripe shape. Although it is not shown in the drawing, a plurality of first conductive regions 20 spaced apart from each other may be coupled to each other at one edge, and a plurality of second conductive regions 30 spaced from each other may be coupled to each other at the other edge. However, the implementations of the invention are not limited thereto.

In this instance, an area of the first conductive regions 20 for collecting carriers (i.e., holes) different from the majority carriers of the base region 110 may be greater than an area of the second conductive regions 30 for collects carriers (i.e. electrons) the same as the majority carriers of the base region 110. Thus, the first conductive region 20 acting as an emitter region may be formed in a sufficient area. By the first conductive region 20 with a large area, holes having a relatively slow moving speed can be effectively collected. As one example, the areas of the first conductive regions 20 and the second conductive regions 30 may be adjusted by varying their widths. That is, a width W1 of the first conductive region 20 may be larger than a width W2 of the second conductive region 30.

First metal electrode layers 422 of the first electrode 42 may have a stripe shape corresponding to the first conductive regions 20 and second metal electrode layers 442 of the second electrode 44 may have a stripe shape corresponding to the second conductive regions 30. Although it is not shown in the drawings for simplicity, the first transparent electrode layers 420 of the first electrode 42 have a stripe shape, each having a larger area than that of the first metal electrode layer 422, and the second transparent electrode layer 420 of the second electrode 44 have a stripe shape, each having a larger area than that of the second metal electrode layer 442. Although it is not shown in the drawings, the first electrodes 42 may be coupled to each other at one edge, and the second electrodes 44 may be coupled to each other at the other edge. However, the implementations of the invention are not limited thereto.

In the solar cell 100 according to the implementation, the first and second electrodes 42 and 44 (particularly, the first and second metal electrode layers 422 and 442) are all positioned on the back surface of the semiconductor substrate 10 so that there is no part for blocking the light at the front surface of the semiconductor substrate 10, thereby minimizing a light loss. Particularly, in the implementation, at least one of the first and second conductive regions 20 and 30 is formed of a compound layer, and thus, the first and second metal electrode layers 422 and 442 of the first electrode 42 and the second electrode 44 may be widely formed in consideration with an electrical property. In this instance, by using the back-contact structure, a shading loss can be reduced.

The solar cell 100 may be manufactured by forming the passivation layer 56 on the back surface of the semiconductor substrate 10 as stated in the descriptions with reference to FIG.4a, forming the first and second conductive regions 20 and 30 thereon as stated in the descriptions with reference to FIG. 4b, forming the first and second transparent electrode layers 420 and 440 formed thereon as stated in the descriptions with reference to FIG. 4c, and forming the first and second metal electrode layers 422 and 442 formed thereon as stated in the descriptions with reference to FIG. 5d. In order to form the first and second conductive regions 20 and 30, the first and second transparent electrode layers 420 and 440, and/or the first and second metal electrode layers 422 and 442 having predetermined patterns, a mask or a mask layer may be used.

The above described features, configurations, effects, and the like are included in at least one of the implementations of the invention, and should not be limited to only one implementation. In addition, the features, configurations, effects, and the like as illustrated in each implementation may be implemented with regard to other implementations as they are combined with one another or modified by those skilled in the art. Thus, content related to these combinations and modifications should be construed as including in the scope and spirit of the invention as disclosed in the accompanying claims.

## Claims

1. A solar cell, comprising:
a semiconductor substrate;
a first conductive region that is configured to extract a carrier from the semiconductor substrate, wherein the first conductive region has a first work function and includes a first compound layer including a first metal;
a second conductive region that is configured to extract a carrier from the semiconductor substrate, wherein the second conductive region has a second work function and includes a second compound layer including a second metal;
a first electrode that is electrically coupled to the first conductive region; and
a second electrode that is electrically coupled to the second conductive region,
wherein at least one of the first electrode or the second electrode comprises a transparent electrode layer and a metal electrode layer that is located on the transparent electrode layer, and
wherein a third work function of the transparent electrode layer of the at least one of the first electrode or the second electrode is the same as or greater than the second work function of the second conductive region and is the same as or smaller than the first work function of the first conductive region.

2. The solar cell of claim 1, wherein a difference between the second work function of the second conductive region and the first work function of the first conductive region is 1 eV or less.

3. The solar cell of claim 2, wherein the difference between the second work function of the second conductive region and the first work function of the first conductive region is within a range of 0.5 to 1 eV.

4. The solar cell of any one preceding claim, wherein the second work function of the second conductive region is greater than 4.2 eV, and
wherein the first work function of the first conductive region is greater than 4.2 eV and is greater than the second work function of the second conductive region.

5. The solar cell of claim 4, wherein the second work function of the second conductive region is greater than 4.2 eV and is the same as or less than 5.2 eV, and
wherein the first work function of the first conductive region is greater than 4.2 eV, is the same as or less than 5.2 eV, and is greater than the second work function of the second conductive region.

6. The solar cell of any one preceding claim, wherein the first electrode comprises a first transparent electrode layer and a first metal electrode layer that is located on the first transparent electrode layer,
wherein the second electrode comprises a second transparent electrode layer and a second metal electrode layer that is located on the second transparent electrode layer, and
wherein a fourth work function of the first transparent electrode layer and a fifth work function of the second transparent electrode layer are the same as or greater than the second work function of the second conductive region and are the same as or smaller than the first work function of the first conductive region.

7. The solar cell of claim 6, wherein at least one of the following is fulfilled:
wherein the first transparent electrode layer and the second transparent electrode layer include a first material;
wherein a difference between the fourth work function of the first transparent electrode layer and the fifth work function of the second transparent electrode layer is less than 0.8 eV; or
wherein the fourth work function of the first transparent electrode layer is greater than 4.2 eV and is the same as or less than 5.2 eV, and the fifth work function of the second transparent electrode layer is greater than 4.2 eV and is the same as or less than 5.2 eV.

8. The solar cell of any one preceding claim, wherein at least one of the following is fulfilled:
wherein the transparent electrode layer includes (i) an indium-based oxide including indium or (ii) a zinc-based oxide including zinc;
wherein the first compound layer or the second compound layer includes a metal oxide layer having an amorphous structure; or
wherein the semiconductor substrate includes an n-type material.

9. The solar cell of any one preceding claim, wherein the first conductive region and the second conductive region are respectively located on different surfaces of the semiconductor substrate, or
wherein the first conductive region and the second conductive region are located on a same surface of the semiconductor substrate.

10. A method for manufacturing a solar cell, comprising:
forming, on a semiconductor substrate, a first conductive region comprising a first compound layer that includes a first metal and a second conductive region comprising a second compound layer that includes a second metal, the first conductive region having a first work function and the second conductive region having a second work function;
forming a first transparent electrode layer of a first electrode that is electrically coupled to the first conductive region and a second transparent electrode layer of a second electrode that is electrically coupled to the second conductive region, the first transparent electrode layer having a third work function and the second transparent electrode layer having a fourth work function; and
forming a first metal electrode layer of the first electrode on the first transparent electrode layer and a second metal electrode layer of the second electrode on the second transparent electrode layer,
wherein at least one of the third work function of the first transparent electrode layer or the fourth work function of the second transparent electrode layer is the same as or greater than the second work function of the second conductive region and is the same as or smaller than the first work function of the first conductive region.

11. The method of claim 10, wherein each of the third work function of the first transparent electrode layer and the fourth work function of the second transparent electrode layer is the same as or greater than the second work function of the second conductive region and is the same as or smaller than the first work function of the first conductive region.

12. The method of claim 11, wherein at least one of the following is fulfilled:
wherein the first transparent electrode layer and the second transparent electrode layer include a second material;
wherein forming the first transparent electrode layer and forming the second transparent electrode layer occur simultaneously in the same process; or
wherein the third work function of the first transparent electrode layer is greater than 4.2 eV and is the same as or less than 5.2 eV, and the fourth work function of the second transparent electrode layer is greater than 4.2 eV and is the same as or less than 5.2 eV.

13. The method of any one of claims 10 to 12, wherein forming the first metal electrode layer and forming the second metal electrode layer occur simultaneously in the same process.
